# EUROPÄISCHE PATENTANMELDUNG

(11) **EP 1 705 716 A1**
(43) Veröffentlichungstag der Anmeldung: **27.09.2006**
(21) Anmeldenummer: 06005588.6
(22) Anmeldetag: 18.03.2006
(51) Int. Cl.: H01L 31/0232

(54) **Halbleiter-Photodetektor und Verfahren zum Herstellen desselben**

(30) Priorität: 24.03.2005 DE 102005013640
(71) Anmelder: ATMEL Germany GmbH, 74072 Heilbronn (DE)
(72) Erfinder: Höhnemann, Holger, Dipl.-Ing., 74211 Leingarten (DE)

(57) **Zusammenfassung**

Die vorliegende Erfindung betrifft einen Halbleiter-Photodetektor mit einem Halbleiter-Substrat (1); und mit oberhalb des Halbleiter-Substrates (1) vorgesehenen Halbleiter-Bereichen (4, 6) mit geeigneten Dotierungen zum Bilden einer Raumladungszone (5) für einen Nachweis von aus Richtung von oben einfallender elektro-magnetischer Strahlung (7); wobei zwischen der Raumladungszone (5) und dem Halbleiter-Substrat (1) mindestens zwei Halbleiter-Spiegelschichten (2, 3) mit sich voneinander unterscheidenden Brechungsindizes zum Bilden eines verteilten Bragg-Reflektors für eine Reflektion der nachzuweisenden Strahlung (7) in Richtung der Raumladungszone (5) vorgesehen sind. Ferner betrifft die vorliegende Erfindung ein Verfahren zur Herstellung eines derartigen Halbleiter-Photodetektors.

## Beschreibung

Die vorliegende Erfindung betrifft einen Halbeiter-Photodetektor und ein Verfahren zur Herstellung eines derartigen Photodetektors.

Photodetektoren dienen im Allgemeinen einer Umwandlung von elektromagnetischer Strahlung in ein elektrischen Strom- oder Spannungssignal. Je nach Art der beteiligten Wechselwirkung zwischen Licht und Materie unterscheidet man zwischen direkter und indirekter opto-elektronischer Signalumwandlung.

Trifft allgemein Licht auf Materie, so können die einzelnen Lichtquanten, d.h. die einzelnen Photonen ihre Energie auf die in der Materie vorhandenen Elektronen übertragen. Die Energie kann dabei beispielsweise die Elektronen des Valenzwandels eines Halbleiters in das Leitungsband heben, was als innerer Photoeffekt bezeichnet wird, wo sie frei beweglich sind und zu erhöhten elektrischen Leitfähigkeit des Halbleiters führen. Findet der innere Photoeffekt im Verarmungsbereich des als Sperrschicht wirkendem p-n Übergangs eines Halbleiters statt, so tritt eine selbstständige photoelektrische Spannung auf, die sich äquivalent der Differenz der Spannungsabfälle in Sperr- und Flussrichtung erweisen. Dieser Effekt wird in Photodetektoren ausgenutzt, wo die Lichtenergie in elektrische Energie umgewandelt wird.

Die durch die Lichteinstrahlung freigesetzten Elektronen bzw. die zurückbleibenden Löcher wandern in zugeordnete Bereiche, wobei sich zwischen diesen Bereichen eine elektrische Spannung ausbildet, welche sich an zugeordneten Anschlussbereichen abgreifen lässt und welche in einem äußeren Leiterkreis einen Stromfluss bewirkt.

Bei einem Halbleiter-Photodetektor erfolgt die Wechselwirkung des einfallenden Lichtes mit den quasi freien Elektronen des Halbleitermaterials und erzeugt direkt durch den photoelektrischen Effekt ein von der eingestrahlten Lichtleistung abhängiges elektrischen Ausgangssignal. Die Absorption der Photonen beeinflusst dabei das elektrische Verhalten im Bereich der sogenannten Raumladungszone der Halbleiter-Photodetektoren. Dabei wird das einfallende Licht in der Raumladungszone zumindest teilweise absorbiert und in Elektronen und Löcher umgewandelt (O/E-Umwandlung). Diese Elektronen und Löcher liefern ein messbares Spannungs- bzw. Stromsignal als Maß für die einfallende bzw. absorbierte Strahlung.

Bei der opto-elektronischen Signalumwandlung ist insbesondere ein möglichst großer Wirkungsgrad im geforderten spektralen Arbeitsbereich wünschenswert, d.h. der Photodetektor soll einen hohen Quantenwirkungsgrad aufweisen. Ferner soll der Photodetektor schnell arbeiten, d.h. eine unverfälschte Wiedergabe der empfangenen Lichtsignale bei hohen Modulationsfrequenzen gewährleisten.

Silizium-Photodetektoren bestehen im Allgemeinen aus einem p-leitenden Silizium-Einkristall, in den eine n-leitende Zone dotiert wurde. Dabei bildet sich eine Sperrschicht aus, wobei der sperrschicht-freie Bereich der n-Zone bei Lichteinstrahlung als negativer Pol des Photodetektors und der Sperrschicht-freie Bereich der p-Zone als positiver Pol wirken kann.

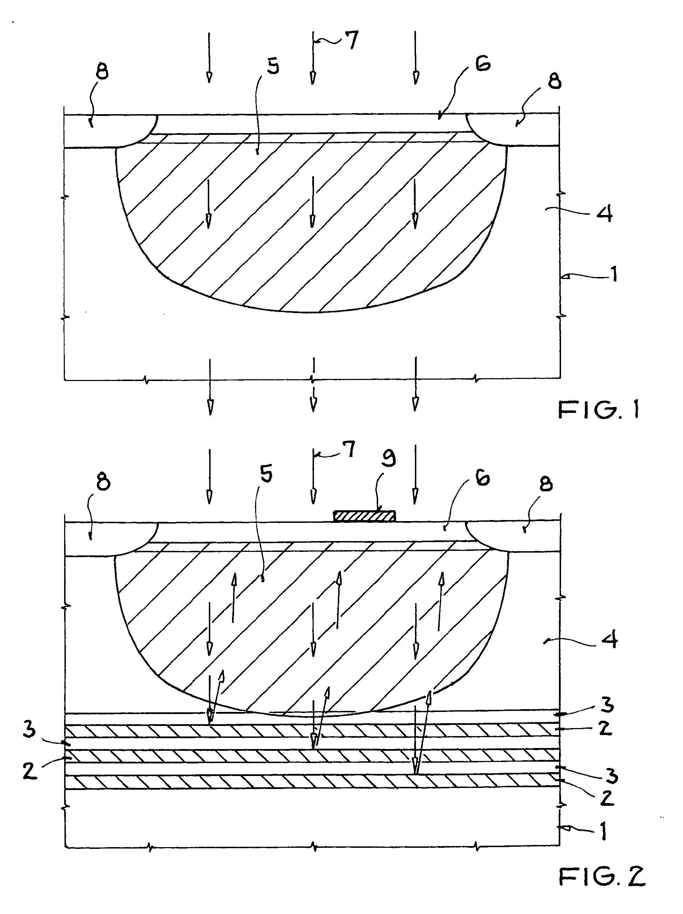

Figur 1 illustriert ein schematische Querschnittsansicht eines Halbleiter-Photodetektors gemäß dem Stand der Technik. Wie in Figur 1 dargestellt ist, ist in dem Substrat 1 ein erster dotierter Bereich 4 und ein zweiter dotierter Bereich 6 derart vorgesehen, das sich eine hinlänglich bekannte Raumladungszone 5 ausbildet. Trifft beispielsweise nahes Infrarotlicht 7 auf die Raumladungszone 5, tritt eine Wechselwirkung der Strahlung 7 mit der Materie der Raumladungszone 5 auf, wobei die Raumladungszone 5 mit einer relativ großen Dicke ausgebildet werden muss, um einen Großteil des eingestrahlten Lichtes 7 verwerten zu können.

An diesem Ansatz hat sich die Tatsache als nachteilig herausgestellt, dass der nicht in der Raumladungszone wechselwirkende Rest der Strahlung 7 mit dem Substrat 1 wechselwirken und vagabundierende Ladungsträger erzeugen kann. Diese außerhalb der Raumladungszone erzeugten Ladungsträger weisen jedoch eine nachteilige Wirkung auf das erzeugte Ausgangssignal auf, da diese Ladungsträger bei der Abnahme des erzeugten Stromes bzw. der erzeugten Spannung in unerwünschter Weise miterfasst und die Signalflanken des optischen Signals abgerundet bzw. abgeschwächt werden.

An dem obigen Ansatz gemäß dem Stand der Technik hat sich ferner die Tatsache als nachteilig herausgestellt, dass der Wirkungsgrad eines derartig aufgebauten Photodetektors lediglich dann zufriedenstellend ist, wenn die Raumladungszone mit einer genügend großen Dicke ausgebildet wird.

Somit ist es Aufgabe der vorliegenden Erfindung, einen Halbleiter-Photodetektor mit einer verbesserten Quantenausbeute, einer reduzierten Erzeugung vagabundierender Ladungsträger und mit einem verringerten Aufbau und ein Verfahren zur Herstellung eines derartigen Halbleiter-Photodetektors zu schaffen.

Diese Aufgabe wird vorrichtungsseitig durch den Halbleiter-Photodetektor mit den Merkmalen gemäß Patentanspruch 1 und verfahrensseitig durch das Verfahren zur Herstellung eines derartigen Halbleiter-Photodetektors mit den Merkmalen gemäß Patentanspruch 13 gelöst.

Die der vorliegenden Erfindung zugrunde liegende Idee besteht darin, dass der Halbleiter-Photodetektor aus einem Halbleiter-Substrat und aus oberhalb des Halbleiter-Substrates vorgesehenen Halbleiter-Bereichen mit geeigneten Dotierungen zum Bilden einer Raumladungszone für einen Nachweis von aus Richtung von oben einfallender elektro-magnetischer Strahlung besteht, wobei zwischen der Raumladungszone und dem Halbleiter-Substrat mindestens zwei Halbleiter-Spiegelschichten mit sich voneinander unterscheidenden Brechungsindizes zum Bilden eines verteilten Bragg-Reflektors für eine Reflektion der nachzuweisenden Strahlung in Richtung der Raumladungszone vorgesehen sind.

Somit wird die auf die Raumladungszone treffende, nicht mit der Raumladungszone wechselwirkende Strahlung durch eine Reflektion an den Bragg-Halbleiter-Schichten in Richtung der Raumladungszone zurückreflektiert, sodass diese Strahlung erneut mit der Raumladungszone wechselwirken kann.

Somit weist die vorliegende Erfindung gegenüber den bekannten Ansätzen gemäß dem Stand der Technik den Vorteil auf, dass das nachzuweisende Licht die Raumladungszone zweimal, d.h. doppelt sooft durchläuft und somit die Quantenausbeute erheblich erhöht.

Ferner wird vorteilhaft verhindert, das die nicht mit der Materie der Raumladungszone wechselwirkende Strahlung vagabundierende Ladungsträger in dem Substrat auslöst, da die Strahlung aufgrund der Reflektion an den Halbleiter-Spiegelschichten vorteilhaft nicht durch das Halbleiter-Substrat hindurchtritt.

Zusätzlich kann beispielsweise die Schichtdicke der Detektorschicht bzw. der Raumladungszone zum Erreichen eines vorgegebenen Wirkungsgrades reduziert werden, da aufgrund des doppelten Strahlengangs der nachzuweisenden Strahlung durch die Raumladungszone die Quantenausbeute erhöht wird, wie oben bereits erläutert wurde.

In den Unteransprüchen finden sich weitere vorteilhafte Ausgestaltungen und Verbesserungen des im Patentanspruch 1 angegebenen Halbleiter-Photodetektors und des im Patentanspruch 13 angegebenen Verfahrens zur Herstellung eines derartigen Photodetektors.

Gemäß einer bevorzugten Weiterbildung ist das Halbleiter-Substrat als ein Silizium-Substrat ausgebildet. Vorzugsweise wird ein hoch p-dotiertes Silizium-Substrat verwendet. Es ist für einen Fachmann offensichtlich, dass andere geeignete Substratmaterialen ebenfalls verwendet werden können.

Gemäß einer weiteren bevorzugten Weiterbildung sind mindestens zwei Halbleiter-Spiegelschichten unmittelbar unterhalb der Raumladungszone vorgesehen. Dadurch wird gewährleistet, dass die nicht mit der Materie der Raumladungszone wechselwirkende Strahlung auf unerwünschte Weise vagabundierende Ladungsträger in dem Bereich des Substrates erzeugt, da die Strahlung vorzugsweise zwischen der Raumladungszone und den Halbleiter-Spiegelschichten verläuft und nicht das Substrat durchläuft. Dies verbessert das Messsignal und gewährleistet eine zuverlässigere Strahlungsmessung.

Vorzugsweise ist mindestens eine Schichtabfolge bestehend aus einer Silizium-Germanium-Spiegelschicht mit einem höheren Brechungsindex und aus einer Silizium-Spiegelschicht mit einem niedrigeren Brechungsindex auf dem Halbleiter-Substrat vorgesehen. Beispielsweise können in etwa drei bis sieben derartige Schichtabfolgen auf dem Halbleiter-Substrat aufgebracht werden. Es ist für einen Fachmann offensichtlich, dass eine beliebige Anzahl an Schichtabfolgen je nach Anwendungsfall möglich ist.

Gemäß einem weiteren bevorzugten Ausführungsbeispiel sind die Silizium-Germanium- und Silizium-Spiegelschichten jeweils als dünne Schichten mit einer Dicke von beispielsweise 40 nm bis 80 nm epitaktisch auf dem Silizium-Substrat aufgewachsen. Ein derartiges epitaktisches Aufbringen gewährleistet vorzugsweise eine geringe Anzahl an Störstellen und reduzierte Herstellungskosten.

Vorzugsweise werden die jeweilige Dicke, der jeweilige Brechungsindex und/oder die Anzahl der einzelnen Halbleiter-Spiegelschichten auf die Wellenlänge der nachzuweisenden Strahlung und/oder den gewünschten Wirkungsgrad abgestimmt.

Nach einer weiteren bevorzugten Weiterbildung wird die Raumladungszone als niedrig p-dotierter Silizium-Bereich epitaktisch aufgewachsen. Hierbei handelt es sich wiederum um eine gängiges, einfach und kostengünstig durchzuführendes Verfahren mit einer geringen Störstellenwahrscheinlichkeit.

Als Dotierungsmaterial für die p-Dotierung wird vorzugsweise Bor verwendet. Es ist jedoch für einen Fachmann offensichtlich, dass andere geeignete Dotierungsmaterialien ebenfalls verwendet werden können.

Oberhalb der Raumladungszone ist vorzugsweise ein n-dotierter Silizium-Bereich vorgesehen. Als Dotierungsmaterial für den n-dotierten Silizium-Bereich wird vorzugsweise Phosphor, Arsen oder dergleichen verwendet. Es ist jedoch für einen Fachmann offensichtlich, dass andere geeignete Dotierungsmaterialien ebenfalls verwendet werden können.

Gemäß einem weiteren bevorzugten Ausführungsbeispiel werden geeignete elektrische Anschlussbereiche für eine Abnahme der durch die nachzuweisende einfallende Strahlung erzeugten Spannung vorgesehen. Hierbei kann beispielsweise in geeigneter Weise eine Elektrode auf dem n-dotierten Silizium-Bereich und eine Elektrode an der Unterseite des Substrates vorgesehen werden.

Nachfolgend werden bevorzugte Ausführungsbeispiele der vorliegenden Erfindung unter Bezugnahme auf die Figuren der Zeichnungen näher erläutert. Von den Figuren zeigen:
- Figur 1;: eine schematische Querschnittsansicht eines Halbleiter-Photodetektors gemäß dem Stand der Technik; und
- Figur 2;: eine schematische Querschnittsansicht eines Halbleiter-Photodetektors gemäß einem bevorzugten Ausführungsbeispiel der vorliegenden Erfindung.

In den Figuren bezeichnen gleiche Bezugszeichen gleiche oder funktionsgleiche Komponenten, sofern nichts Gegenteiliges angegeben ist.

Figur 2 illustriert eine schematische Querschnittsansicht eines Halbleiter-Photodetektors gemäß einem bevorzugten Ausführungsbeispiel der vorliegenden Erfindung.

Wie in Figur 2 ersichtlich ist, wird auf einem beispielsweise Silizium-Substrat 1 eine erste Halbleiter-Spiegelschicht 2 mit einem ersten Brechungsindex aufgebracht. Beispielsweise wird als erste Halbleiter-Spiegelschicht 2 eine Silizium-Germanium-Schicht 2 epitaktisch auf dem Silizium-Substrat 1 als dünne Schicht aufgewachsen. Die Schichtdicke der Silizium-Germanium-Schicht 2 beträgt beispielsweise 40 nm bis 80 nm und ist vorzugsweise an die Wellenlänge der nachzuweisenden Strahlung 7 und an die Dicke und den Brechungsindex einer weiteren Halbleiter-Spiegelschicht 3 abgestimmt.

Der Brechungsindex der Silizium-Germanium-Schicht 2 kann dabei durch die Konzentration an Germanium gesteuert werden, wobei ein höherer Anteil an Germanium einen höheren Brechungsindex der Silizium-Germanium-Schicht 2 bewirkt. Es ist bei einer Auswahl des Anteils von Germanium in der Silizium-Germanium-Schicht 2 ein Kompromiss zwischen einem höheren Brechungsindex bei erhöhtem Anteil von Germanium und einer erhöhten Verspannung des Siliziumgitters, wodurch eine höhere Anzahl an Defektstellen zu erwarten ist, einzugehen.

Das Aufwachsen wird vorzugsweise mittels eines gängigen epitaktischen Aufwachsverfahrens bewerkstelligt, welches ein einfaches und kostengünstiges Verfahren darstellt.

Wie in Figur 2 ferner ersichtlich ist, wird auf die Silizium-Germanium-Schicht 2 anschließend eine zweite Halbleiter-Spiegelschicht 3 aufgebracht. Beispielsweise ist die zweite Halbleiter-Spiegelschicht 3 als Silizium-Schicht 3 ausgebildet und weist ebenfalls eine Dicke von vorzugsweise 40 nm bis 80 nm auf. Die Silizium-Schicht 3 besitzt dabei vorzugsweise einen geringeren Brechungsindex als die Silizium-Germanium-Schicht 2, sodass ein Strahlengang an dem Übergang von der Silizium-Schicht 3 zu der Silizium-Germanium-Schicht 2 bragg-reflektiert wird. Somit bildet die Schichtabfolge bestehend aus der Silizium-Germanium-Schicht 2 und der Silizium-Spiegelschicht 3 einen Bragg-Reflektor für die einfallende, nachzuweisende Strahlung 7.

Es ist für einen Fachmann offensichtlich, dass mehrere dieser Schichtabfolgen bestehend aus einer Silizium-Germanium-Schicht 2 und einer Silizium-Schicht 3 hintereinander auf dem Silizium-Substrat 1 aufgebracht werden können. In dem in Figur 2 dargestellten Ausführungsbeispiel sind drei dieser Schichtabfolgen exemplarisch illustriert.

Die Anzahl der Schichtabfolgen, die Dicke der einzelnen Bragg-Schichten 2 und 3 sowie die Brechungsindizes sind vorzugsweise an die Wellenlänge der nachzuweisenden Strahlung 7 angepasst. Dabei soll der Reflektionsgrad bezüglich der nachzuweisenden Strahlung 7 einen möglichst großen Wert annehmen, sodass ein möglichst großer Anteil der Strahlung 7 einen doppelten Strahlengang durch die mit dem Bezugszeichen 5 dargestellte Raumladungszone erfährt.

Die Silizium-Schicht 3 ist vorzugsweise analog zu der Silizium-Germanium-Schicht 2 mittels eines gängigen epitaktischen Verfahrens auf der Silizium-Germanium-Schicht 2 aufgewachsen. Andere Verfahren sind selbstverständlich ebenfalls vorstellbar.

Wie in Figur 2 ferner ersichtlich ist, wird vorzugsweise direkt oberhalb der Bragg-Schichtabfolge bestehend aus den Schichten 2 und 3 eine intrinsische Silizium-Schicht 4 mit einer geeigneten Dotierung derart epitaktisch aufgewachsen, dass sich vorzugsweise direkt über den Bragg-Schichten 2 und 3 die Raumladungszone 5 ausbilden kann. Derartige intrinsische Schichten weisen den Vorteil auf, dass deren Störstellenzahl einen äußerst niedrigen Wert annehmen.

Beispielsweise ist das Silizium-Substrat 1 als hoch p-dotiertes Silizium-Substrat und die intrinsische Silizium-Schicht 4 als niedrig p-dotierte Silizium-Schicht ausgebildet. Dabei kann als p-Dotierungsmaterial Bor oder ein ähnlich geeignetes Material verwendet werden.

Auf der niedrig p-dotierten Silizium-Schicht 4 wird anschließend eine n-dotierte Silizium-Schicht 6 ausgebildet, beispielsweise mittels eines gängigen lmplantations- oder Diffusionsverfahrens. Als Dotierungsmaterial kann hierbei vorteilhaft Phosphor, Arsen oder dergleichen verwendet werden.

Die Dotierungen der Silizium-Schichten 4 und 6 sind derart gewählt, dass sich die vorab erwähnte Raumladungszone 5 ausbildet, in welcher die einfallende Strahlung 7 eine Wechselwirkung mit der Materie derart eingeht, dass Ladungsträger bzw. Löcher zum Erzeugen einer elektrischen Spannung bzw. eines elektrischen Stromes erzeugt werden. Diese erzeugte Spannung kann über geeignete Anschlussbereiche 8, 9 abgegriffen werden.

Somit schafft die vorliegende Erfindung einen Halbleiter-Photodetektor, bei welchem aufgrund der Integration einer oder mehrerer Spiegelschichten zur Bildung eines Bragg-Reflektors zwischen dem Substrat 1 und der Detektorschicht 5 der Anteil der vagabundierenden Ladungsträger deutlich reduziert werden kann. Ferner kann die Schichtdicke der Detektorschicht 5 zudem reduziert werden, da die nachzuweisende Strahlung 7 die Raumladungszone 5 aufgrund der Reflektion an den Bragg-Schichten 2 und 3 zweimal durchläuft und somit die Quantenausbeute erhöht wird.

Zusätzlich benötigen bei dem erfindungsgemäßen Photo-Detektor die Schichten zum Erreichen eines ausreichend unterschiedlichen Brechungsindex vorteilhaft einen geringen Germanium-Gehalt, sodass keine zu hohen Spannungen des Silizium-Gitters aufgrund des Germanium-Anteils auftreten.

Ferner sind die erfindungsgemäßen Aufbauten im Schichtstapel äußerst stabil gegenüber Hochtemperaturprozessen, sodass derartige Photodetektoren auf einfache und kostengünstige Weise bei bisherigen Hochtemperaturverfahren implementiert werden können.

Der oben beschriebene Halbleiter-Photodetektor kann beispielsweise zur Erfassung eines nahen Infrarotlichtes bzw. einer elektromagnetischen Strahlung mit einer Wellenlänge von 700 nm und 1100 nm verwendet werden. Es ist für einen Fachmann jedoch offensichtlich, dass der oben beschriebene Erfindungsgedanke prinzipiell auf sämtliche Strahlungen über den gesamten Wellenlängenbereich anwendbar ist. Der Wirkungsgrad des erfindungsgemäßen Photodetektors ist dabei abhängig von der Anzahl der Schichtabfolgen, den ausgewählten Materialien, den zugehörigen Brechungsindizes sowie von den gewählten Schichtdicken.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar.

### Bezugszeichenliste

- 1: Silizium-Substrat
- 2: erste Bragg-Spiegelschicht
- 3: zweite Bragg-Spiegelschicht
- 4: niedrig p-dotierte Silizium-Schicht
- 5: Raumladungszone/Detektorschicht
- 6: niedrig n-dotierte Silizium-Schicht
- 7: nachzuweisende Strahlung
- 8: Anschlussbereiche
- 9: Anschlussbereich

## Patentansprüche

1. Halbleiter-Photodetektor mit:
einem Halbleiter-Substrat (1); und
oberhalb des Halbleiter-Substrates (1) vorgesehenen Halbleiter-Bereichen (4, 6) mit geeigneten Dotierungen zum Bilden einer Raumladungszone (5) für einen Nachweis von aus Richtung von oben einfallen der elektro-magnetischer Strahlung (7);
**dadurch gekennzeichnet,**
**dass** zwischen der Raumladungszone (5) und dem Halbleiter-Substrat (1) mindestens zwei Halbleiter-Spiegelschichten (2, 3) mit sich voneinander unterscheidenden Brechungsindizes zum Bilden eines Bragg-Reflektors für eine Reflektion der nachzuweisenden Strahlung (7) in Richtung der Raumladungszone (5) vorgesehen sind.

2. Halbleiter-Photodetektor nach Anspruch 1,
**dadurch gekennzeichnet,**
**dass** das Halbleiter-Substrat (1) als Silizium-Substrat, vorzugsweise als hoch p-dotiertes Silizium-Substrat, ausgebildet ist.

3. Halbleiter-Photodetektor nach Anspruch 1 oder 2,
**dadurch gekennzeichnet,**
**dass** die mindestens zwei Halbleiter-Spiegelschichten (2, 3) unmittelbar unterhalb der Raumladungszone (5) vorgesehen sind.

4. Halbleiter-Photodetektor nach wenigstem einem der vorhergehenden Ansprüche,
**dadurch gekennzeichnet,**
**dass** mindestens eine Schichtabfolge bestehend aus einer Silizium-Germanium-Spiegelschicht (2) mit einem höheren Brechungsindex und einer Silizium-Spiegelschicht (3) mit einem niedrigeren Brechungsindex auf dem Halbleiter-Substrat (1) vorgesehen ist.

5. Halbleiter-Photodetektor nach wenigstens einem der vorhergehenden Ansprüche,
**dadurch gekennzeichnet,**
**dass** in etwa drei bis sieben Schichtabfolgen bestehend aus einer Silizium-Germanium-Spiegelschicht (2) mit einem höheren Brechungsindex und einer Silizium-Spiegelschicht (3) mit einem niedrigeren Brechungsindex auf dem Halbleiter-Substrat (1) vorgesehen sind.

6. Halbleiter-Photodetektor nach Anspruch 4 oder 5,
**dadurch gekennzeichnet,**
**dass** die Silizium-Germanium-Spiegelschicht (2) und die Silizium-Spiegelschicht (3) jeweils als dünne Schichten, beispielsweise mit einer Dikke von 40 nm bis 80 nm, auf dem Silizium-Substrat (1) aufgewachsen sind.

7. Halbleiter-Photodetektor nach wenigstens einem der vorhergehenden Ansprüche,
**dadurch gekennzeichnet,**
**dass** die jeweilige Dicke, der jeweilige Brechungsindex und/oder die Anzahl der einzelnen Halbleiter-Spiegelschichten (2, 3) auf die Wellenlänge der nachzuweisenden Strahlung (7) und/oder den gewünschten Wirkungsgrad des Photodetektors abgestimmt sind.

8. Halbleiter-Photodetektor nach wenigstens einem der vorhergehenden Ansprüche,
**dadurch gekennzeichnet,**
**dass** die Raumladungszone (5) als niedrig p-dotierter Silizium-Bereich ausgebildet ist, vorzugsweise als epitaktisch aufgebrachte, intrinsische Silizium-Schicht.

9. Halbleiter-Photodetektor nach Anspruch 8,
**dadurch gekennzeichnet,**
**dass** das p-Dotierungsmaterial als Bor oder dergleichen ausgebildet ist.

10. Halbleiter-Photodetektor nach wenigstens einem der vorhergehenden Ansprüche,
**dadurch gekennzeichnet,**
**dass** oberhalb der Raumladungszone (5) ein n-dotierter Silizium-Bereich vorgesehen ist.

11. Halbleiter-Photodetektor nach Anspruch 10,
**dadurch gekennzeichnet,**
**dass** das n-Dotierungsmaterial als Phosphor, Arsen oder dergleichen ausgebildet ist.

12. Halbleiter-Photodetektor nach wenigstens einem der vorhergehenden Ansprüche,
**dadurch gekennzeichnet,**
**dass** geeignete elektrische Anschlussbereiche (8, 9) für eine Abnahme der durch die nachzuweisende, einfallende Strahlung (7) erzeugten elektrischen Spannung vorgesehen sind.

13. Verfahren zur Herstellung eines Halbleiter-Photodetektors mit folgenden Verfahrensschritten:
- Vorsehen eines Halbleiter-Substrates (1);
- Bilden von Halbleiter-Bereichen (4, 6) oberhalb des Halbleiter-Substrates (1) mit geeigneten Dotierungen zum Bilden einer Raumladungszone (5) für einen Nachweis von aus Richtung von oben einfallender elektro-magnetischer Strahlung (7); und
- Bilden von mindestens zwei Halbleiter-Spiegelschichten (2, 3) zwischen der Raumladungszone (5) und dem Halbleiter-Substrat (1) mit sich voneinander unterscheidenden Brechungsindizes zum Bilden eines Bragg-Reflektors für eine Reflektion der nachzuweisenden Strahlung (7) in Richtung der Raumladungszone (5).

14. Verfahren nach Anspruch 13,
**dadurch gekennzeichnet,**
**dass** das Halbleiter-Substrat (1) als Silizium-Substrat, vorzugsweise als hoch p-dotiertes Silizium-Substrat, ausgebildet wird.

15. Verfahren nach Anspruch 13 oder 14,
**dadurch gekennzeichnet,**
**dass** die mindestens zwei Halbleiter-Spiegelschichten (2, 3) unmittelbar unterhalb der Raumladungszone (5) ausgebildet werden.

16. Verfahren nach wenigstens einem der Ansprüche 13 bis 15,
**dadurch gekennzeichnet,**
**dass** mindestens eine Schichtabfolge bestehend aus einer Silizium-Germanium-Spiegelschicht (2) mit einem höheren Brechungsindex und einer Silizium-Spiegelschicht (3) mit einem niedrigeren Brechungsindex auf dem Halbleiter-Substrat (1) ausgebildet wird.

17. Verfahren nach wenigstens einem der Ansprüche 13 bis 16,
**dadurch gekennzeichnet,**
**dass** in etwa drei bis sieben Schichtabfolgen bestehend aus einer Silizium-Germanium-Spiegelschicht (2) mit einem höheren Brechungsindex und einer Silizium-Spiegelschicht (3) mit einem niedrigeren Brechungsindex auf dem Halbleiter-Substrat (1) ausgebildet werden.

18. Verfahren nach Anspruch 16 oder 17,
**dadurch gekennzeichnet,**
**dass** die Silizium-Germanium-Spiegelschicht (2) und die Silizium-Spiegelschicht (3) jeweils als dünne Schichten, beispielsweise mit einer Dikke von 40 nm bis 80 nm, auf dem Silizium-Substrat (1) aufgewachsen werden.

19. Verfahren nach wenigstens einem der Ansprüche 13 bis 18,
**dadurch gekennzeichnet,**
**dass** die jeweilige Dicke, der jeweilige Brechungsindex und/oder die Anzahl der einzelnen Halbleiter-Spiegelschichten (2, 3) auf die Wellenlänge der nachzuweisenden Strahlung (7) und/oder den gewünschten Wirkungsgrad des Photodetektors abgestimmt werden.

20. Verfahren nach wenigstens einem der Ansprüche 13 bis 19,
**dadurch gekennzeichnet,**
**dass** die Raumladungszone (5) als niedrig p-dotierter Silizium-Bereich ausgebildet wird, vorzugsweise als epitaktisch aufgebrachte, intrinsische Silizium-Schicht.

21. Verfahren nach Anspruch 20,
**dadurch gekennzeichnet,**
**dass** als p-Dotierungsmaterial Bor oder dergleichen verwendet wird.

22. Verfahren nach wenigstens einem der Ansprüche 13 bis 21,
**dadurch gekennzeichnet,**
**dass** oberhalb der Raumladungszone (5) ein n-dotierter Silizium-Bereich ausgebildet wird.

23. Verfahren nach Anspruch 22,
**dadurch gekennzeichnet,**
**dass** als n-Dotierungsmaterial Phosphor, Arsen oder dergleichen verwendet wird.

24. Verfahren nach wenigsten einem der Ansprüche 13 bis 23,
**dadurch gekennzeichnet,**
**dass** geeignete elektrische Anschlussbereiche (8, 9) für eine Abnahme der durch die nachzuweisende, einfallende Strahlung erzeugten Spannungen vorgesehen werden.
